# FASCICULE DE BREVET EUROPEEN

(11) **EP 4 256 685 B1**
(45) Date de publication et mention de la délivrance du brevet: **07.10.2026**
(21) Numéro de dépôt: 21820572.2
(22) Date de dépôt: 29.11.2021
(51) Int. Cl.: H02M 1/08, H02M 7/219, H03K 17/687, H02M 7/5387, H02M 1/00

(54) **CONVERTISSEUR DE PUISSANCE**
STROMRICHTER
POWER CONVERTER

(30) Priorité: 01.12.2020 FR 2012453
(43) Date de publication de la demande: 11.10.2023
(73) Titulaire: Commissariat à l'Energie Atomique et aux Energies Alternatives, 75015 Paris (FR)
(72) Inventeur: BAILLY, Alain, 13790 Rousset (FR); BERGOGNE, Dominique, 38054 Grenoble Cedex 09 (FR)
(74) Mandataire: Cabinet Beaumont
(86) Numéro de dépôt international: PCT/EP2021/083287
(87) Numéro de publication internationale: WO 2022/117481

(56) Documents cités:
- US-A1- 2002 131 286
- US-A1- 2018 351 475
- US-B1- 10 840 798

## Description

La présente demande revendique la priorité de la demande de brevet français 20/12453 déposée le 1er décembre 2020, ayant pour titre "convertisseur de puissance".

### Domaine technique

La présente description concerne de façon générale les dispositifs électroniques et plus particulièrement les convertisseurs de puissance. La présente description concerne plus précisément la commande d'interrupteurs de puissance d'un tel convertisseur.

### Technique antérieure

Les convertisseurs de puissance sont largement utilisés en électronique et l'on connait de nombreux montages de convertisseurs de puissance.

Les convertisseurs auxquels s'appliquent les modes de réalisation décrits comportent un bras de redressement ou bras d'onduleur comportant deux interrupteurs de puissance en série entre deux nœuds d'application d'une tension continue.

Un problème récurrent des convertisseurs de puissance à bras d'onduleur réside dans la commande des interrupteurs de puissance à partir de circuits électroniques basse tension, typiquement à partir des signaux numériques fournis par un microcontrôleur.

La publication de brevet américain US 10,840,789 B1 divulgue un dispositif électronique comprenant un premier interrupteur "lowside" et un deuxième interrupteur "high-side", électriquement en série avec le premier interrupteur. Un module de pilotage du deuxième interrupteur est configuré pour fournir, au deuxième interrupteur, un signal de commande de grille, référencé au potentiel d'un troisième noeud au point milieu entre les deux interrupteurs.

### Résumé de l'invention

Il existe un besoin d'amélioration des convertisseurs de puissance et, plus particulièrement des circuits de commande de bras d'interrupteurs de puissance.

Un mode de réalisation pallie tout ou partie des inconvénients des circuits de commande et convertisseurs de puissance connus.

Un mode de réalisation prévoit un dispositif électronique selon la revendication 1.

Un mode de réalisation prévoit un procédé de commande d'un dispositif électronique selon la revendication 14.

Un mode de réalisation prévoit un convertisseur alternatif-continu selon la revendication 15.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique, un mode de réalisation d'un convertisseur alternatif-continu ;
la figure 2 représente, de façon très schématique, un mode de réalisation d'un bras d'onduleur et de module électronique de commande ;
la figure 3 représente, de façon très schématique, un autre mode de réalisation d'un dispositif électronique ;
la figure 4 représente, de façon très schématique, un détail du dispositif de la figure 3 selon une variante de réalisation ;
la figure 5 illustre, sous forme de chronogrammes, un mode de fonctionnement du montage de la figure 3 dans un convertisseur du type de celui illustré par la figure 1 ;
la figure 6 illustre, sous forme de chronogrammes, un autre mode de fonctionnement du montage de la figure 3 dans un convertisseur du type de celui illustré par la figure 1 ; et
la figure 7 représente, de façon très schématique et sous forme de blocs, un exemple de circuit de validation de signaux de commande d'un bras d'onduleur.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications alimentées par les modes de réalisation des convertisseurs décrits n'ont pas été détaillées, les modes de réalisation décrits étant compatibles avec toute application d'un convertisseur de puissance à bras d'interrupteurs de puissance.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Pour simplifier la description qui suit et sauf précision contraire, lorsque l'on fait référence à des états hauts et bas de signaux de commande ou de polarisation, on considère des niveaux correspondants aux potentiels d'alimentation des circuits générant ces états, négligeant ainsi les chutes de tension à l'état passant de transistors, diodes ou résistances fixant ces niveaux.

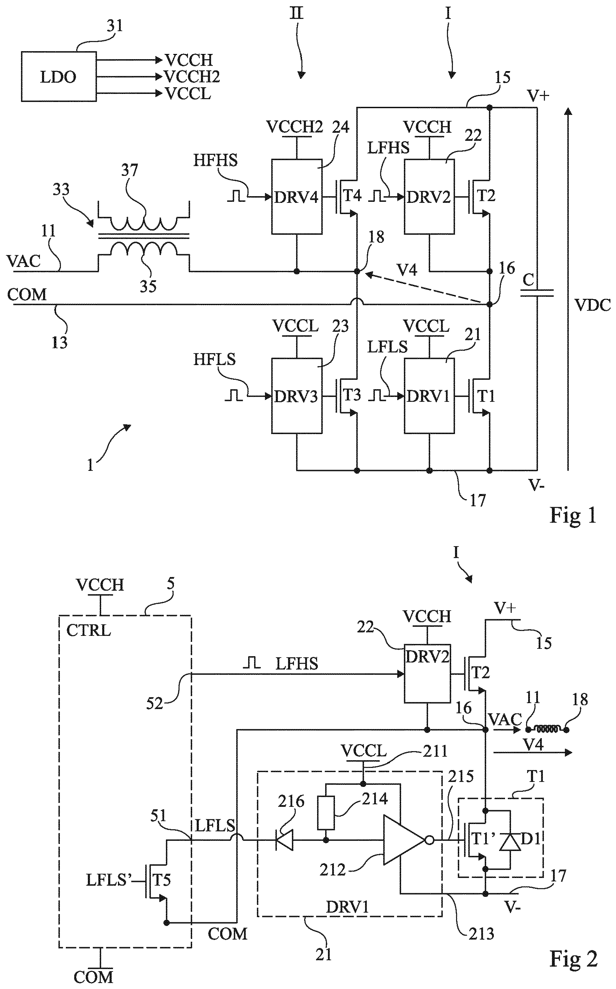

La figure 1 représente, de façon très schématique, un mode de réalisation d'un convertisseur alternatif-continu.

Le convertisseur 1 a, dans cet exemple, pour fonction de convertir une tension alternative VAC, par exemple la tension du réseau de distribution électrique, appliquée entre deux nœuds ou bornes 11 (VAC) et 13 (COM) en une tension continue VDC aux bornes d'un élément capacitif C, entre deux nœuds ou bornes 15 (V+) et 17 (V-).

La structure de redressement est constituée de quatre interrupteurs T1, T2, T3, T4, typiquement des transistors à effet de champ à canal N, répartis dans deux bras I et II comportant chacun deux interrupteurs en série entre les nœuds 15 et 17, les deux bras étant donc en parallèle entre les nœuds 15 et 17. Le premier bras I comporte les transistors T1 et T2 en série entre les nœuds 15 et 17, le point milieu 16 (source du transistor T2 et drain du transistor T1) étant relié, de préférence connecté, au nœud 13. Le deuxième bras II comporte les transistors T4 et T3 en série entre les nœuds 15 et 17, le point milieu 18 (source du transistor T4 et drain du transistor T3) étant relié, de préférence connecté, au nœud 11. Les drains des transistors T2 et T4 sont interconnectés ou communs. Les sources des transistors T1 et T3 sont interconnectées ou communes.

Chaque transistor T1, T2, T3, T4 est commandé par un circuit de polarisation ou driver 21 (DRV1), 22 (DRV2), 23 (DRV3) et 24 (DRV4) fournissant, sur la grille du transistor concerné, un signal de commande en créneaux. Le rôle des circuits 21, 22, 23, 24 est de mettre en forme des signaux numériques en créneaux, respectivement LFLS, LFHS, HFLS et HFHS, fournis par un microcontrôleur (non représenté en figure 1).

Les transistors à canal N étant rendus passants par application d'une tension grille-source positive, les circuits 21 à 24 doivent être alimentés de façon appropriée pour être mesure de mettre en forme les signaux de commande. Ainsi, le niveau bas ou de référence de la tension d'alimentation des circuits 21 à 24 correspond au potentiel de source du transistor T1 à T4 correspondant. Le niveau haut ou positif de la tension d'alimentation de chaque circuit 21 à 24 doit, par ailleurs, être supérieur d'une valeur correspondant au moins à la tension seuil des transistors T1 à T4 afin de pouvoir appliquer sur la grille du transistor concerné une tension grille-source suffisante pour le rendre passant. Ainsi, les circuits 21 et 23 de commande des transistors T1 et T3, généralement désignés "bas" ou "côté bas" (Low Side) sont alimentés par une tension VCCL référencée au nœud 17. Les circuits 22 et 24 de commande des transistors T2 et T4, généralement désignés "haut" ou "côté haut" (High Side) sont alimentés par une tension VCCH référencée au nœud 16 pour le circuit 22 (source du transistor T2) et par une tension VCCH2 référencée au nœud 18 pour le circuit 24 (source du transistor T4). Les transistors T1, T2, T3 et T4 étant tous de même type (à canal N), leurs tensions de commande doivent être référencées à leurs sources respectives.

La génération des tensions VCCH, VCCH2 et VCCL fait généralement appel à un ou plusieurs régulateurs 31 (LDO) de type régulateur(s) linéaire(s) à faible chute de tension série, alimenté(s) via un transformateur 33. Un enroulement ou élément inductif primaire 35 du transformateur 33 est intercalé entre les nœuds 11 et 18. Un enroulement ou élément inductif secondaire 37 du transformateur 33, couplé magnétiquement au premier enroulement 33, fournit une basse tension (typiquement de quelques volts et inférieure à 10 volts) au(x) régulateur(s) 31.

Le fonctionnement d'un convertisseur tel qu'illustré par la figure 1 est usuel. Le premier bras I, généralement appelé bras d'onduleur ou de redressement, est commandé à une fréquence proche, de préférence identique, à la fréquence de la tension alternative VAC, soit typiquement inférieure au kilohertz, par exemple de quelques dizaines d'Hertz (50 ou 60 Hz pour le réseau de distribution électrique) à quelques centaines d'Hertz pour les réseaux alternatifs des avions. Le deuxième bras, généralement appelé bras de régulation ou bras de découpage, est commandé à une fréquence de plusieurs kilohertz à quelques Mégahertz, en modulation de largeur d'impulsions en fonction des besoins d'énergie de la charge alimentée par la tension VDC. Les signaux HFHS et HFLS sont donc des signaux à haute fréquence (High Frequency) par rapport aux signaux LFHS et LFLS qui sont à basse fréquence (Low Frequency).

Dans un convertisseur du type de celui de la figure 1, une difficulté réside dans la conversion des signaux numériques fournis par le contrôleur en signaux de commande de grille des transistors. Dans un convertisseur classique, tous les signaux numériques sont référencés au potentiel le plus bas, soit le potentiel V-. La commande des transistors T1 et T3 ne pose alors pas de problème, les références des signaux HFLS et LFLS étant les mêmes que celles des signaux de commande fournis par les circuits 21 et 23. Par contre, côté circuit 22 de commande du transistor haut T2 du bras d'onduleur, il est classiquement nécessaire de prévoir un isolateur entre le signal de commande LFHS fourni par le microcontrôleur et le potentiel de référence (le potentiel COM) du signal fourni par le circuit 22. En effet, le potentiel COM est flottant et est soumis à de forts dV/dt ayant, pour amplitude, l'amplitude de plusieurs centaines de volts de la tension VAC. L'utilisation de ce potentiel comme référence de potentiel pour le signal de commande du transistor T2, généré à partir de signaux fournis par un microcontrôleur alimenté par une tension de quelques volts, nécessite une isolation galvanique ou un décaleur de niveau entre la référence V- (nœud 17) de la tension d'alimentation du microcontrôleur et le potentiel COM, ce qui complique le circuit.

Les modes de réalisation de la présente description visent à éviter la nécessité d'un isolateur ou d'un décaleur de niveau pour générer les signaux de commande du bras d'onduleur et plus particulièrement du transistor haut d'un bras d'onduleur.

Pour ce faire, on prévoit de référencer le signal de commande numérique du transistor haut du bras d'onduleur au potentiel de référence de la tension alternative. En d'autres termes, on prévoit de référencer la tension d'alimentation du contrôleur, générant les signaux de commande, au potentiel du point milieu entre les transistors du bras d'onduleur.

La figure 2 représente, de façon très schématique, un mode de réalisation d'un bras d'onduleur et de module électronique de commande.

Pour simplifier, seul le bras d'onduleur I du convertisseur de la figure 1 est représenté en figure 2. Toutefois, les modes de réalisation décrits s'appliquent à un bras d'onduleur seul ou associé à un autre bras d'un convertisseur de puissance, par exemple un bras de régulation ou de découpage du type de celui décrit en relation avec la figure 1. On se réfèrera donc à des éléments du convertisseur de la figure 1 lorsque cela est utile à l'exposé de la structure ou du fonctionnement du dispositif de la figure 2.

Le bras d'onduleur est, comme précédemment, constitué de deux transistors T2 et T1 à effet de champ, en série entre des nœuds 15 (V+) et 17 (V-) d'une tension continue VDC (figure 1). Chaque transistor T1, T2 est commandé à partir d'un signal en créneau LFLS, LFHS fourni par un contrôleur 5 (CTRL) et transitant par un circuit de mise en forme 21 (DRV1), respectivement 22 (DRV2) du module de commande décrit.

Selon les modes de réalisation décrits, l'alimentation du contrôleur 5 est référencé au potentiel COM du nœud 16, qui sert donc de référence aux signaux numériques LFHS et LFLS. Le potentiel positif d'alimentation du contrôleur 5 est, par exemple, le potentiel VCCH généré par le régulateur linéaire 31 (figure 1) ou un autre potentiel de quelques volts (par exemple de l'ordre de 3,3 volts), référencé au potentiel COM.

Le fait de référencer le potentiel d'alimentation du contrôleur 5 au potentiel COM simplifie considérablement la commande des transistors du bras d'onduleur. En particulier, aucun circuit d'isolation galvanique, ni décaleur de niveau de référence, n'est nécessaire au niveau des circuits 21 et 22 du module de commande.

Dans l'exemple de la figure 2, on suppose que les sorties fournissant les signaux LFHS et LFLS sont à drain ouvert, c'est-à-dire qu'elles sont constituées de drains de transistors à canal N (T5 pour l'étage bas) dont les sources sont au potentiel COM de référence de l'alimentation du contrôleur 5.

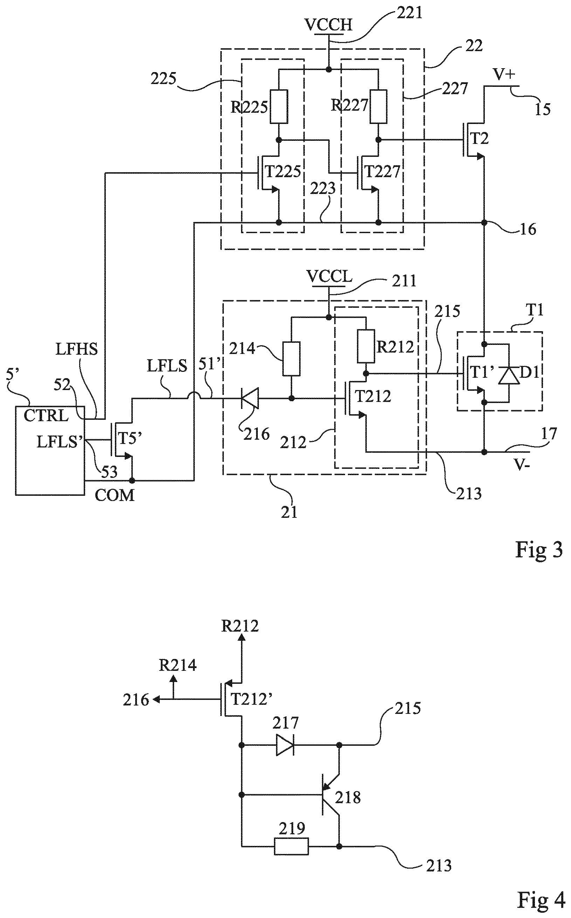

Ainsi, côté circuit 22, le transistor T2 peut, dans un mode de réalisation simplifié, être commandé directement par le signal LFHS issu du microcontrôleur 5 (borne de sortie 52). De préférence, on prévoit néanmoins un circuit 22 de mise en forme, constitué d'un simple double inverseur MOS comme on le verra par la suite en relation avec la figure 4, alimenté par la tension VCCH référencée au potentiel COM. Aucun décalage du potentiel de référence n'est cependant requis.

Côté circuit 21, il suffit d'inverser un signal de commande LFLS' pour obtenir le signal LFLS à appliquer au circuit 21 de commande de grille du transistor T5. Ainsi, le transistor T5 fournit, sur son drain, le signal LFLS. Le transistor T5 est commandé par un signal LFLS' généré pour respecter une absence de conduction simultanée des transistors T1 et T2. Le circuit 21 comporte, dans cet exemple, un amplificateur inverseur 212, alimenté entre les potentiels VCCL (nœud 211) et V- (nœud 213 ou 17), dont la sortie est reliée, de préférence connectée, à la grille du transistor T1. L'entrée de l'amplificateur 212 est reliée à la borne 211 par une résistance 214 de tirage (pull-up) et, par l'intermédiaire d'une diode 216, au drain du transistor T5 (borne 51 de sortie du contrôleur 5).

Le fonctionnement du bras d'onduleur I de la figure 2 exploite une conduction inverse du transistor T1. On tire profit de la présence, dans le cas d'un transistor MOSFET réalisé sur silicium, de la diode intrinsèque D1 qui est présente dans le transistor à canal N constituant le transistor T1 pour utiliser la conduction inverse du transistor T1. Ainsi, le transistor T1 correspond, comme illustré en figure 2, à un transistor T1', entre source et drain duquel est présente une diode D1, l'anode de la diode D1 étant côté source du transistor T1'.

De plus, on exploite avantageusement la présence d'un élément inductif sur la borne au potentiel COM. Cet élément inductif correspond, dans l'exemple de la figure 1, à l'enroulement primaire 35 du transformateur 33. En variante, une borne d'un élément inductif est directement connectée à la borne 16.

La figure 3 représente, de façon très schématique, un autre mode de réalisation d'un dispositif électronique.

Dans l'exemple de la figure 3, on suppose que le transistor T5' fournissant le signal LFLS est externe au contrôleur 5'. Le signal LFLS' est alors fourni sur une sortie 53 du contrôleur reliée, de préférence connectée, à la grille du transistor externe T5' dont le drain est relié, de préférence connecté, au nœud 16. La source du transistor T5' est reliée, de préférence connectée, à la cathode de la diode 216 du circuit 21 (nœud 51'). Dans le mode de réalisation de la figure 3, on illustre l'inverseur 212 sous la forme d'une résistance R212 en série avec un transistor MOS T212 entre les bornes 211 et 213, le transistor T212 étant passant quand la diode 216 est bloquée. Le nœud 215 entre la résistance R212 et le transistor T212 (drain du transistor T212) est relié, de préférence connecté, à la grille du transistor T1'.

Le circuit 22 est illustré, dans cet exemple, sous la forme de deux inverseurs MOS successifs. Un premier inverseur 225 comporte une résistance R225 en série avec un transistor MOS T225, à canal N, entre des bornes 221 et 223 d'alimentation du circuit 22, respectivement reliées, de préférence connectées, aux nœuds aux potentiels VCCH et COM. La grille du transistor T225 est reliée, de préférence connectée, à la borne 52 du contrôleur 5'. Un deuxième inverseur 227 comporte une résistance R227 en série avec un transistor MOS T227, à canal N, entre les bornes 221 et 223. La grille du transistor T227 est reliée, de préférence connectée, au drain du transistor T225, donc au nœud de connexion de la résistance R225 au transistor T225. Le drain du transistor T227 (nœud entre la résistance 227 et le transistor T227) constitue la sortie du circuit 22 reliée, de préférence connectée, à la grille du transistor T2.

La figure 4 représente, de façon très schématique, un détail du dispositif de la figure 3 selon une variante de réalisation.

Dans l'exemple de la figure 4, le transistor T212 de la figure 3 est remplacé par un transistor T212' à canal P dont la source est reliée à la borne 211 par la résistance R212 (non représentée) et dont la grille est reliée, par la résistance 214 (non représentée) à la borne 211, et par la diode 216 au nœud 51' (figure 3). Le drain du transistor T212' est relié, par l'intermédiaire d'une diode 217, au nœud 215, l'anode de la diode 217 étant côté drain du transistor T212'. Un transistor bipolaire 218 (PNP) relie les nœuds 215 et 213, la base du transistor 218 étant reliée, de préférence connectée, au drain du transistor T212' et, par une résistance de polarisation 219, au nœud 213.

Le montage de la figure 4 revient à réaliser un inverseur du type de celui de la figure 3, le transistor 218 étant bloqué quand le transistor T212' est passant, donc quand la diode 216 est passante.

Le fonctionnement des modes de réalisation décrits dépend de l'évolution de la tension (V4, figures 1 et 2) entre les nœuds 18 et 16 en fonction du temps, donc du signe de la tension V4 par rapport à la tension sinusoïdale VAC.

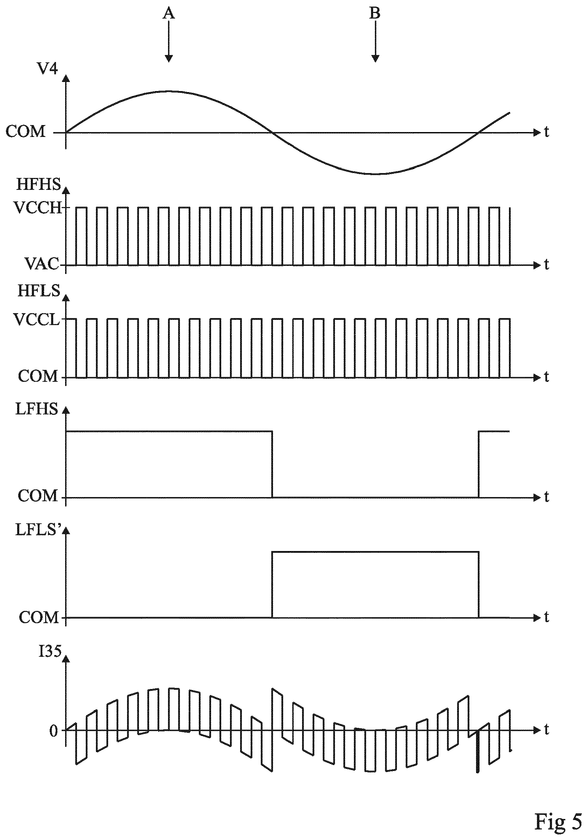

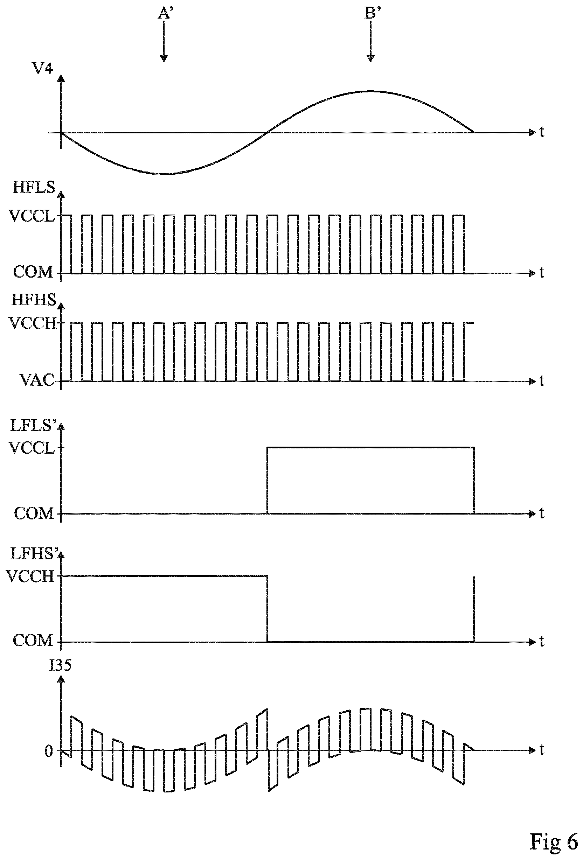

Ce fonctionnement est illustré ci-après par les figures 5 et 6 qui illustrent deux scénarios selon que la tension V4 est en phase ou en opposition de phase avec la tension VAC. Le courant I35 dans l'inductance 35 est pris, par convention, dans le sens du nœud 11 au nœud 18.

La figure 5 illustre, sous forme de chronogrammes, le fonctionnement du montage de la figure 3 dans un convertisseur du type de celui illustré par la figure 1 dans le cas où la tension V4 est positive pendant la première demi-période (positive) de la tension VAC.

Ces chronogrammes représentent, respectivement, des exemples d'allures de la tension V4, du signal HFLS, du signal HFHS, du signal LFHS, du signal LFLS' de commande du transistor T5', et du courant I35 dans l'élément inductif 35.

Pendant la première demi-période A, la tension V4 est positive (par rapport à la référence COM). Le signal LFHS est à l'état haut. Par conséquent, le transistor T225 est passant et le transistor T227 reste bloqué et la sortie du circuit 22 est à l'état haut, rendant le transistor T2 conducteur. Côté bas, le signal LFLS' est à l'état bas. Le transistor T5' (ou T5, figure 2) est donc bloqué, ce qui rend flottante la cathode de la diode 216. La grille du transistor T212 est alors polarisée au potentiel VCCL par la résistance 214. Le transistor T212 conduit et force la grille du transistor T1' au niveau bas, le maintenant bloqué. La diode D1 est également bloquée, le potentiel COM étant supérieur au potentiel V-. Pendant cette demi-période, le courant I35 dans l'inductance est positif et circule par le transistor T3 ou par le transistor T4 en fonction de l'état des signaux HFHS et HFLS, en étant rebouclé par le transistor T2 qui est passant.

Pendant la deuxième demi-période B, la tension V4 est négative. Le signal LFHS est à l'état bas et le transistor T225 reste ouvert, ce qui rend conducteur le transistor T227 et bloque le transistor T2. Le courant dans l'inductance 35 continue cependant à circuler, le transistor T1 étant en conduction inverse par la diode D1 (la tension V4 étant devenue négative). Le courant I35 circule donc en fonction de l'état des signaux HFHS et HFLS, par le transistor T4, le condensateur C et la diode D1, ou par le transistor T3 et la diode D1. Côté bas, le signal LFLS' est à l'état haut. Le transistor T5' (ou T5) est donc passant, ce qui décharge la grille du transistor T212 via la diode 216. L'ouverture du transistor T212 provoque, via la résistance R212, la mise à l'état haut de la grille du transistor T1' qui devient passant.

La figure 6 illustre, sous forme de chronogrammes, le fonctionnement du montage de la figure 3 dans un convertisseur du type de celui illustré par la figure 1 dans le cas où la tension V4 est négative pendant la première demi-période (positive) de la tension VAC.

Ces chronogrammes représentent, respectivement, des exemples d'allures de la tension V4, du signal HFLS, du signal HFHS, du signal LFLS' de commande du transistor T5', du signal LFHS et du courant I35 dans l'élément inductif 35.

Pendant la première demi-période A', la tension V4 est négative (par rapport à la référence COM). Le signal LFHS est à l'état haut. Par conséquent, le transistor T225 est passant et le transistor T227 reste bloqué et la sortie du circuit 22 est à l'état haut, rendant le transistor T2 conducteur. Côté bas, le signal LFLS' est à l'état bas. Le transistor T5' (ou T5, figure 2) est donc bloqué, ce qui rend flottante la cathode de la diode 216. La grille du transistor T212 est alors polarisée au potentiel VCCL par la résistance 214. Le transistor T212 conduit et il force la grille du transistor T1' au niveau bas, le maintenant bloqué. La diode D1 est également bloquée, le potentiel COM étant supérieur au potentiel V-. Pendant cette demi-période, le courant I35 dans l'inductance est négatif et circule par le transistor T2 et, en fonction de l'état des signaux HFHS et HFLS, par le transistor T4 ou par le condensateur C et le transistor T3.

Pendant la deuxième demi-période B', la tension V4 est positive. Le signal LFHS est à l'état bas et le transistor T225 reste ouvert, ce qui rend conducteur le transistor T227 et bloque le transistor T2. Le courant dans l'inductance 35 continue cependant à circuler par le transistor T2 en inverse (par sa diode intrinsèque) et, en fonction de l'état des signaux HFHS et HFLS, le condensateur C et le transistor T3, ou le transistor T4. Lorsque le transistor T3 conduit, la tension V4 étant positive, le transistor T1 est forcé en conduction inverse et le potentiel V- devient égal au potentiel COM. Côté bas, le signal LFLS' est à l'état haut. Le transistor T5' (ou T5) est donc passant, ce qui décharge la grille du transistor T212 via la diode 216. L'ouverture du transistor T212 provoque, via la résistance R212, la mise à l'état haut de la grille du transistor T1' qui devient passant.

Un avantage des modes de réalisation décrits ci-dessus est qu'ils permettent d'éviter de recourir à un isolateur ou décaleur du niveau de référence de potentiel d'alimentation de référence du contrôleur par rapport au reste du circuit.

Les modes de réalisation décrits sont particulièrement adaptés à une intégration à base de transistors dits transistor à haute mobilité électronique HEMT (en anglais "High Electron Mobility Transistor"), c'est-à-dire réalisant une conduction entre drain et source par une interface entre semiconducteurs à grande largeur de bande interdite (en anglais "wide bandgap"), les électrons étant mobiles le long de ladite interface. Ces semiconducteurs peuvent être du nitrure de Gallium GaN et du nitrure d'aluminium-gallium AlGaN. On parle alors de transistor de type HEMT à GaN.

Le cas échéant, un interrupteur ou transistor de type HEMT comprend, ou est constitué par, un transistor de type HEMT, de préférence à GaN, ou plusieurs transistors de type HEMT, de préférence à GaN, en série et/ou en parallèle. Des transistors HEMT permettent de bloquer des tensions plus élevées et permettent des commutations plus rapides que d'autres types de transistors à effet de champ.

De préférence, les transistors compris dans, ou constituant, les transistors à canal N de type HEMT sont à enrichissement (en anglais "enhancement mode HEMT"). Ces interrupteurs ou transistors sont alors de type dit normalement ouvert ou bloqué (en anglais "normally OFF"), c'est-à-dire non passant en l'absence de tension de commande (tension grille-source). En variante, le ou les transistors compris dans, ou constituant, l'un et/ou l'autre des transistors de type HEMT peuvent également être à appauvrissement ou à déplétion (en anglais "depletion mode HEMT"). L'interrupteur concerné est alors également de type dit HEMT à appauvrissement ou à déplétion. Ces interrupteurs ou transistors sont alors de type dit normalement fermé ou passant (en anglais "normally ON"), c'est-à-dire passant en l'absence de tension de commande (autrement dit, à tension de commande nulle). En particulier les éléments résistifs peuvent être réalisés par des transistors normalement fermés.

Dans le cas d'un transistor de type HEMT (comme dans le cas d'un transistor en carbure de silicium ou SiC qui constitue une autre variante), le transistor ne comporte pas à proprement parler de diode intrinsèque (par opposition à un transistor de type MOSFET réalisé sur silicium) mais présente un fonctionnement en inverse permettant une conduction comme le ferait une diode. Par conséquent, le fonctionnement exposé avec des transistors T1 et T2 à diode intrinsèque D1 se transpose à des transistors de type GaN ou SiC.

Selon un mode de réalisation, on prévoit de détecter la polarité du potentiel COM par rapport à une référence externe au bras d'onduleur (donc la polarité de la tension VAC) afin d'empêcher toute mise en conduction simultanée des transistors d'un même bras, indépendamment des signaux de commande générés par le contrôleur (5 ou 5'). Cela permet de sécuriser le fonctionnement du convertisseur en cas de dysfonctionnement du microcontrôleur.

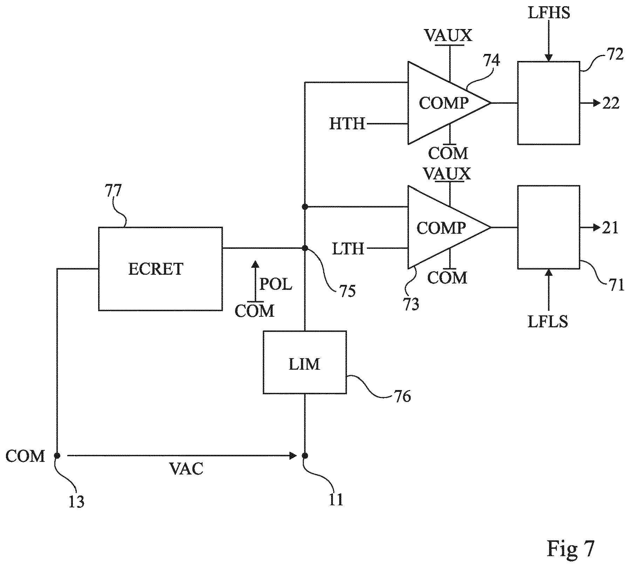

La figure 7 représente, de façon très schématique et sous forme de blocs, un exemple de circuit de validation de signaux de commande des étages haut et bas d'un bras d'onduleur en fonction de la polarité de la tension VAC.

Selon cet exemple, on intercale entre les signaux LFLS et LFHS générés par le microcontrôleur et les circuits de commande respectifs 21 et 22, des circuits logiques 71 et 72 autorisant ou non la transmission des signaux LFLS et LFHS. Ces circuits 71 et 72 sont contrôlés par des comparateurs (COMP) 73 et 74 d'un niveau POL d'un nœud 75 représentatif de la polarité de la tension alternative VAC. Le comparateur 73 a pour rôle de détecter quand la tension VAC est positive pour autoriser la fermeture du transistor T1. Le comparateur 74 a pour rôle de détecter quand la tension VAC est négative, pour autoriser la fermeture du transistor T2. Le signal POL est obtenu en limitant la tension VAC (limiteur 76 entre le nœud 11 et le nœud 75) et préférentiellement en écrêtant le niveau du nœud COM (écrêteur 77 entre le nœud 13 et le nœud 75). Le signal POL est comparé, par le comparateur 74, à un seuil bas LTH et, par le comparateur 73, à un seuil haut HTH. Les comparateurs 73 et 74 sont alimentés par une tension VAUX, référencée au potentiel COM, mais externe au bras d'onduleur. Il peut s'agir, par exemple, de la tension VCCH.

Le montage illustré par la figure 7 comporte en outre des circuits logiques de fourniture des signaux de commande (LFHS, LFLS) aux premier (21) et deuxième (22) circuits, ces circuits étant commandés par des détecteurs de polarité de la tension alternative par rapport audit point-milieu (16).

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, la réalisation pratique d'un circuit du type de celui de la figure 7 est à la portée de l'homme du métier à partir des indications fonctionnelles fournies.

## Revendications

1. Dispositif électronique comprenant :
un premier interrupteur (T1) ayant un seul sens de blocage de tension ;
un deuxième interrupteur (T2), électriquement en série avec le premier interrupteur entre un premier nœud (15) et un deuxième nœud (17) d'application d'une tension continue (VDC) ;
un module configuré pour fournir, au deuxième interrupteur, un signal de commande, référencé au potentiel (COM) d'un troisième nœud correspondant au point milieu (16) entre les deux interrupteurs et comportant :
un premier circuit (21) de commande du premier interrupteur (T1), configuré pour recevoir un premier signal de commande (LFLS) en créneaux, référencé au potentiel (COM) dudit troisième nœud (16) ; et
un deuxième circuit (22) de commande du deuxième interrupteur (T2), configuré pour recevoir un deuxième signal de commande (LFHS) en créneaux, référencé au potentiel (COM) dudit troisième nœud (16),
le premier circuit (21) comportant :
un montage de mise en forme du premier signal (LFLS) entre un niveau d'une borne (211) de fourniture d'un premier potentiel positif (VCCL) positif par rapport audit deuxième nœud (17) et ledit niveau du deuxième nœud (17), le montage de mise en forme comportant un amplificateur inverseur (212) ;
une première diode (216) entre l'entrée de l'amplificateur inverseur (212) et une deuxième borne d'entrée du premier circuit (21) à laquelle est appliqué le premier signal, l'anode de la diode (216) étant côté entrée de l'amplificateur inverseur (212) ; et
une première résistance (214) entre la première borne (211) et l'entrée de l'amplificateur inverseur (212) ; et
un contrôleur (5 ; 5') et un transistor à effet de champ (T5 ; T5'), interne ou externe audit contrôleur (5), reliant la cathode de la première diode (216) audit troisième nœud (16), le contrôleur (5 ; 5') étant configuré pour commander ledit transistor à effet de champ (T5) par un signal (LFLS') représentant l'inverse du premier signal de commande (LFLS).

2. Dispositif selon la revendication 1, dans lequel ledit troisième nœud (16) est relié à un quatrième nœud (13) d'application d'une tension alternative (VAC).

3. Dispositif selon la revendication 1 ou 2, dans lequel l'amplificateur inverseur (212) comporte, en série entre la première borne (211) et le deuxième nœud (17), une deuxième résistance et un transistor MOS (T212), la grille du transistor MOS (T212) étant reliée à l'anode de la première diode (216) et le point milieu entre la deuxième résistance et le transistor MOS (T212) étant reliée à une troisième borne (215) de commande du premier interrupteur (T1).

4. Dispositif selon l'une quelconque des revendications 1 ou 2, dans lequel l'amplificateur inverseur comporte en série entre la première borne (211) et le deuxième nœud (17), une deuxième résistance (R212), un transistor MOS (T212') et une troisième résistance (219), le drain du transistor MOS (T212') étant relié, par l'intermédiaire d'une deuxième diode (217), à une troisième borne (215) de commande du premier interrupteur (T1), un transistor bipolaire (218) dont la base est reliée au drain du transistor MOS (T212') reliant la troisième borne (215) au deuxième nœud (17).

5. Dispositif selon l'une quelconque des revendications 1 à 4, dans lequel le premier interrupteur (T1) présente une conduction inverse à la manière d'une diode.

6. Dispositif selon la revendication 5, dans lequel le premier interrupteur comporte au moins une diode (D1) dont la cathode est tournée vers ledit troisième nœud (16).

7. Dispositif selon l'une quelconque des revendications 1 à 6, dans lequel le premier interrupteur (T1) comporte en outre un transistor à effet de champ (T1').

8. Dispositif selon l'une quelconque des revendications 1 à 7, dans lequel le deuxième circuit (22) comporte, entre une borne d'entrée d'application du deuxième signal et une borne de sortie, un montage de mise en forme du deuxième signal (LFHS) entre ledit premier potentiel positif (VCCH) et ledit potentiel (COM) dudit troisième nœud (16).

9. Dispositif selon l'une quelconque des revendications 1 à 8, dans lequel le premier interrupteur et le deuxième interrupteur sont des transistors à effet de champ (T1, T2) à canal N.

10. Dispositif selon l'une quelconque des revendications 1 à 9, dans lequel le ou les transistors à effet de champ sont des transistors HEMT.

11. Dispositif selon la revendication 2 et l'une quelconque des revendications 1, 3 à 10, comportant en outre un circuit de validation desdits signaux de commande (LFHS, LFLS) en fonction de la polarité de la tension alternative (VAC).

12. Dispositif selon la revendication 11, dans lequel ledit circuit de validation comporte des circuits logiques (71, 72) de fourniture des signaux de commande (LFHS, LFLS) aux premier (21) et deuxième (22) circuits, ces circuits logiques étant configurés pour être commandés par des détecteurs de polarité de la tension alternative (VAC) par rapport audit troisième nœud (16).

13. Convertisseur de puissance comportant :
un dispositif selon l'une quelconque des revendications 1 à 12 ; et
un troisième interrupteur (T4) et un quatrième interrupteur (T3) en série entre le premier nœud (15) et le deuxième nœud (17) d'application de la tension continue (VDC).

14. Procédé de commande d'un dispositif selon l'une quelconque des revendications 1, 3 à 13, dans lequel ledit troisième nœud (16) est relié à un quatrième nœud (13 d'application d'une tension alternative (VAC), comprenant la mise à l'état passant du premier interrupteur (T1) et la mise à l'état bloqué du deuxième interrupteur (T2) lorsque la tension alternative (VAC) a un premier signe, et la mise à l'état bloqué du premier interrupteur (T1) et la mise à l'état passant du deuxième interrupteur (T2) lorsque la tension alternative a un deuxième signe.

15. Convertisseur alternatif-continu, comportant un dispositif selon l'une quelconque des revendications 1 à 13 ou comportant un dispositif selon l'une quelconque des revendications 1, 3 à 13 et configuré pour mettre en oeuvre un procédé selon la revendication 14.

## Patentansprüche

1. Eine elektronische Einrichtung, die Folgendes aufweist:
einen ersten Schalter (T1), der eine einzige Spannungssperrrichtung aufweist; einen zweiten Schalter (T2), der elektrisch in Reihe mit dem ersten Schalter zwischen einem ersten Knoten (15) und einem zweiten Knoten (17) zum Anlegen einer Gleichspannung (VDC) angeordnet ist;
ein Modul, eingerichtet zum Versorgen des zweiten Schalters mit einem Steuersignal, das auf das Potential (COM) eines dritten Knotens bezogen ist, der dem Mittelpunkt (16) der beiden Schalter entspricht, und das Folgendes aufweist:
einen ersten Schaltkreis (21) zum Steuern des ersten Schalters (T1), eingerichtet zum Empfangen eines ersten Rechteckimpuls-Steuersignals (LFLS), das auf das Potential (COM) des genannten dritten Knotens (16) bezogen ist; und
einen zweiten Schaltkreis (22) zum Steuern des zweiten Schalters (T2), eingerichtet zum Empfangen eines zweiten Rechteckimpuls-Steuersignals (LFHS), das auf das Potential (COM) des genannten dritten Knotens (16) bezogen ist, wobei der erste Schaltkreis (21) Folgendes aufweist:
eine Anordnung zum Formen des ersten Signals (LFLS) zwischen einem Pegel eines Anschlusses (211) zum Liefern eines ersten positiven Potentials (VCCL), das in Bezug auf den genannten zweiten Knoten (17) positiv ist, und dem genannten Pegel des zweiten Knotens (17), wobei die Anordnung zum Formen einen invertierenden Verstärker (212) aufweist;
eine erste Diode (216) zwischen dem Eingang des invertierenden Verstärkers (212) und einem zweiten Eingangsanschluss des ersten Schaltkreises (21), an den das erste Signal angelegt wird, wobei sich die Anode der Diode (216) auf der Eingangsseite des invertierenden Verstärkers (212) befindet; und
einen ersten Widerstand (214) zwischen dem ersten Anschluss (211) und dem Eingang des invertierenden Verstärkers (212); und
eine Steuerung (5; 5') und einen Feldeffekttransistor (T5; T5'), der innerhalb oder außerhalb der genannten Steuerung (5) angeordnet ist und die Kathode der ersten Diode (216) mit dem genannten dritten Knoten (16) koppelt, wobei die Steuerung (5; 5') eingerichtet zum Steuern des genannten Feldeffekttransistors (T5) mit einem Signal (LFLS') ist, das die Inverse des ersten Steuersignals (LFLS) darstellt.

2. Die Einrichtung nach Anspruch 1, wobei der genannte dritte Knoten (16) mit einem vierten Knoten (13) zum Anlegen einer Wechselspannung (VAC) gekoppelt ist.

3. Die Einrichtung nach Anspruch 1 oder 2, wobei der invertierende Verstärker (212) in Reihe zwischen dem ersten Anschluss (211) und dem zweiten Knoten (17) einen zweiten Widerstand und einen MOS-Transistor (T212) aufweist, wobei das Gate des MOS-Transistors (T212) mit der Anode der ersten Diode (216) gekoppelt ist und der Mittelpunkt des zweiten Widerstands und des MOS-Transistors (T212) mit einem dritten Steueranschluss (215) des ersten Schalters (T1) gekoppelt ist.

4. Die Einrichtung nach einem der Ansprüche 1 bis 3, wobei der invertierende Verstärker in Reihe zwischen dem ersten Anschluss (211) und dem zweiten Knoten (17) einen zweiten Widerstand (R212), einen MOS-Transistor (T212') und einen dritten Widerstand (219) aufweist, wobei der Drain des MOS-Transistors (T212') über eine zweite Diode (217) mit einem dritten Steueranschluss (215) des ersten Schalters (T1) gekoppelt ist, wobei ein Bipolartransistor (218), dessen Basis mit dem Drain des MOS-Transistors (T212') gekoppelt ist, den dritten Anschluss (215) mit dem zweiten Knoten (17) koppelt.

5. Die Einrichtung nach einem der Ansprüche 1 bis 4, wobei der erste Schalter (T1) eine Rückwärtsleitung wie eine Diode aufweist.

6. Die Einrichtung nach Anspruch 5, wobei der erste Schalter wenigstens eine Diode (D1) aufweist, deren Kathode dem genannten dritten Knoten (16) zugewandt ist.

7. Die Einrichtung nach einem der Ansprüche 1 bis 6, wobei der erste Schalter (T1) ferner einen Feldeffekttransistor (T1') aufweist.

8. Die Einrichtung nach einem der Ansprüche 1 bis 7, wobei der zweite Schaltkreis (22) zwischen einem Eingangsanschluss zum Anlegen des zweiten Signals und einem Ausgangsanschluss eine Anordnung zum Formen des zweiten Signals (LFHS) zwischen dem genannten ersten positiven Potential (VCCH) und dem genannten Potential (COM) des genannten dritten Knotens (16) aufweist.

9. Die Einrichtung nach einem der Ansprüche 1 bis 8, wobei der erste Schalter und der zweite Schalter N-Kanal-Feldeffekttransistoren (T1, T2) sind.

10. Die Einrichtung nach einem der Ansprüche 1 bis 9, wobei der oder die Feldeffekttransistoren HEMT-Transistoren sind.

11. Die Einrichtung nach Anspruch 2 und einem der Ansprüche 1, 3 bis 10, ferner aufweisend einen Schaltkreis zum Validieren der genannten Steuersignale (LFHS, LFLS) auf Grundlage der Polarität der Wechselspannung (VAC).

12. Die Einrichtung nach Anspruch 11, wobei der genannte Validierungsschaltkreis Logikschaltungen (71, 72) zum Liefern der Steuersignale (LFHS, LFLS) an den ersten (21) und den zweiten (22) Schaltkreis aufweist, wobei diese Logikschaltungen eingerichtet sind, durch Detektoren der Polarität der Wechselspannung (VAC) in Bezug auf den genannten dritten Knoten (16) gesteuert zu werden.

13. Ein Leistungswandler, der Folgendes aufweist:
eine Einrichtung nach einem der Ansprüche 1 bis 12; und
einen dritten Schalter (T4) und einen vierten Schalter (T3) in Reihe zwischen dem ersten Knoten (15) und dem zweiten Knoten (17) zum Anlegen der Gleichspannung (VDC).

14. Ein Verfahren zum Steuern einer Einrichtung nach einem der Ansprüche 1, 3 bis 13, wobei der genannte dritte Knoten (16) mit einem vierten Knoten (13) zum Anlegen einer Wechselspannung (VAC) gekoppelt ist, das das Versetzen des ersten Schalters (T1) in den Ein-Zustand und das Versetzen des zweiten Schalters (T2) in den Aus-Zustand, wenn die Wechselspannung (VAC) ein erstes Vorzeichen aufweist, und das Versetzen des ersten Schalters (T1) in den Aus-Zustand und das Versetzen des zweiten Schalters (T2) in den Ein-Zustand, wenn die Wechselspannung ein zweites Vorzeichen aufweist, aufweist.

15. Ein Wechselspannungs-Gleichspannungs-Wandler, der eine Einrichtung nach einem der Ansprüche 1 bis 13 aufweist oder eine Einrichtung nach einem der Ansprüche 1, 3 bis 13 aufweist und eingerichtet zum Implementieren eines Verfahrens nach Anspruch 14 ist.

## Claims

1. Electronic device comprising:
a first switch (T1) having a single voltage blocking direction;
a second switch (T2), electrically in series with the first switch between a first node (15) and a second node (17) of application of a DC voltage (VDC);
a module configured to supply the second switch with a control signal referenced to the potential (COM) of a third node corresponding to the midpoint (16) of the two switches, and comprising:
a first circuit (21) for controlling the first switch (T1), configured to receive a first square-pulse control signal (LFLS), referenced to the potential (COM) of said third node (16); and
a second circuit (22) for controlling the second switch (T2), configured to receive a second square-pulse control signal (LFHS), referenced to the potential (COM) of said third node (16),
the first circuit (21) comprising:
an assembly for shaping the first signal (LFLS) between a level of a terminal (211) for delivering a first positive potential (VCCL), positive with respect to said second node (17), and said level of the second node (17), the shaping assembly comprising an inverting amplifier (212);
a first diode (216) between the input of the inverting amplifier (212) and a second input terminal of the first circuit (21) to which is applied the first signal, the anode of the diode (216) being on the input side of the inverting amplifier (212); and
a first resistor (214) between the first terminal (211) and the input of the inverting amplifier (212) ; and
a controller (5; 5') and a field-effect transistor (T5; T5'), internal or external to said controller (5), coupling the cathode of the first diode (216) to said third node (16), the controller (5; 5') being configured to control said field-effect transistor (T5) with a signal (LFLS') representing the inverse of the first control signal (LFLS).

2. Device according to claim 1, wherein said third node (16) is coupled to a fourth node (13) of application of an AC voltage (VAC).

3. Device according to claim 1 or 2, wherein the inverting amplifier (212) comprises, in series between the first terminal (211) and the second node (17), a second resistor and a MOS transistor (T212), the gate of the MOS transistor (T212) being coupled to the anode of the first diode (216) and the midpoint of the second resistor and of the MOS transistor (T212) being coupled to a third control terminal (215) the first switch (T1).

4. Device according to any of claims 1 to 3, wherein the inverting amplifier comprises, in series between the first terminal (211) and the second node (17), a second resistor (R212), a MOS transistor (T212'), and a third resistor (219), the drain of the MOS transistor (T212') being coupled, via a second diode (217), to a third control terminal (215) of the first switch (T1), a bipolar transistor (218) having its base coupled to the drain of the MOS transistor (T212') coupling the third terminal (215) to the second node (17).

5. Device according to any of claims 1 to 4, wherein the first switch (T1) has a reverse conduction, like a diode.

6. Device according to the claim 5, wherein the first switch comprises at least one diode (D1) having its cathode facing said third node (16).

7. Device according to any of claims 1 to 6, wherein the first switch (T1) further comprises a field-effect transistor (T1').

8. Device according to any of claims 1 to 7, wherein the second circuit (22) comprises, between an input terminal of application of the second signal and an output terminal, an assembly for shaping the second signal (LFHS) between said first positive potential (VCCH) and said potential (COM) of said third node (16).

9. Device according to any of claims 1 to 8, wherein the first switch and the second switch are N-channel field-effect transistors (T1, T2).

10. Device according to any of claims 1 to 9, wherein the field-effect transistor(s) are HEMT transistors.

11. Device according to claim 2 and any of claims 1, 3 to 10, further comprising a circuit for validating said control signals (LFHS, LFLS) based on the polarity of the AC voltage (VAC).

12. Device according to claim 11, wherein said validation circuit comprises logic circuits (71, 72) for supplying the control signals (LFHS, LFLS) to the first (21) and second (22) circuits, these logic circuits being configured to be controlled by detectors of the polarity of the AC voltage (VAC) with respect to said third node (16).

13. Power converter comprising:
a device according to any of claims 1 to 12; and
a third switch (T4) and a fourth switch (T3) in series between the first node (15) and the second node (17) of application of the DC voltage (VDC).

14. Method of controlling a device according to any of claims 1, 3 to 13, wherein said third node (16) is coupled to a fourth node (13) of application of an AC voltage (VAC), comprising the setting to the on state of the first switch (T1) and the setting to the off state of the second switch (T2) when the AC voltage (VAC) has a first sign, and the setting to the off state of the first switch (T1) and the setting to the on state of the second switch (T2) when the AC voltage has a second sign.

15. AC-to-DC converter, comprising a device according to any of claims 1 to 13 or comprising a device according to any of claims 1, 3 to 13 and configured to implement a method according to claim 14.
